Europäisches Patentamt

European Patent Office

Office européen des brevets

(11) Publication number: **0 150 258**
A2

# EUROPEAN PATENT APPLICATION

(21) Application number: 84109638.1

(22) Date of filing: 13.08.84

(51) Int. Cl.⁴: **G 06 F 11/26**, G 01 R 31/28

(30) Priority: 30.01.84 US 575367

(71) Applicant: VALID LOGIC SYSTEMS, INC., 2820 Orchard Parkway, San Jose California 95314 (US)

(43) Date of publication of application: 07.08.85 Bulletin 85/32

(72) Inventor: Widdoes, Curtis L., Jr., 19700 Duff, Sunnyvale California 94086 (US)

(74) Representative: KUHNEN & WACKER Patentanwaltsbüro, Schneggstrasse 3-5 Postfach 1729, D-8050 Freising (DE)

(84) Designated Contracting States: DE FR GB IT

(54) Method for propagating unknown digital values in a hardware based complex circuit simulation system.

(57) In a circuit system simulation model which may comprise a combination of the physical device to be modeled and means for controlling the physical device at normal operating speeds, a method is provided for propagating a simulated unknown signal value which comprises exciting the simulation model with differing pattern sequences a plurality of times, during each excitation sequence changing at least one input value in the input sequence, comparing the sampled values of each resultant output signal, and setting or recognizing as an unknown value any specific output signal which differs as a result of the change in the input sequence. Modification, repetition, sampling and comparison of patterns may be repeated a number of times. Only a fraction of the possible input patterns need to be presented to indicate the propagation of unknown values.

ACTORUM AG

9707-1-3

# METHOD FOR PROPAGATING UNKNOWN DIGITAL VALUES
# IN A HARDWARE BASED COMPLEX CIRCUIT
# SIMULATION SYSTEM

## BACKGROUND OF THE INVENTION

This invention relates to modeling of operation of complex large scale integration (LSI) or very large scale integration (VLSI) devices for use in development and testing of complex circuitry and systems. More specifically, the invention relates to logic simulation and testing of complex digital circuitry and systems including those capable of executing instructions under program control in which performance characteristics of LSI or VLSI devices must also be accurately simulated. In particular, this invention is related to solutions to problems related to development of logic-simulation models built around hardware library elements, as disclosed in the parent application. It is believed that to date no one other than the present inventor and his co-workers is presently active in this field.

A logic-simulation model of a device is a diagnostic tool which accurately mimics logical and timing behavior of a device in normal operation. The purpose of such a model is to verify both logic and timing of an operational digital system containing the device. In a logic-simulation model, internal operation and internal structure need not be similar to that of the actual device being simulated. The only prerequisite is that the operation as externally observed be similar to the actual device being modeled.

Conventional logic-simulation models have been implemented with software. The present invention, in contrast, is a development around logic simulation models based on library elements which are the actual hardware devices and which interact with other library elements through a combination of hardware and software.

Software logic-simulation models have been of two types, namely structural models and behavioral models. A structural model mimics actual internal logical structure of a device from which observable functional behavior follows. A behavioral model merely mimics external logical and timing behavior.

Software models of complex devices have numerous disadvantages. First, they are relatively costly and time consuming to develop. Also, to design an accurate model, specifications of the device must be gathered and thoroughly understood. This has been a serious limitation because manufacturers of devices are generally reluctant to disclose such details. Moreover, the specifications required for modeling a device are typically much more detailed than those relevant to a typical user of the device.

Furthermore, software simulation models are characteristically slow because of the amount of computation required to simulate device functions. Typically, the amount of computation required to simulate external components is negligible compared with the amount of computation required to simulate the complex device itself. In fact, software modulation models are frequently too slow to be of practical utility.

One presumed advantage of software simulation models is an ability to generate and deal with a signal

0150258

3

in an unknown logic value in the system circuit to be simulated. A real device, however, does not have the capability of generating or understanding such unknown-valued signals. The consequence is the generation of an unambiguous-valued signal output when a signal representing an unknown value should be the subject of analysis. Initially, this inventor found this problem to be a detriment to development of versatile simulation models built around hardware library elements. With the invention described hereinbelow it is possible to use hardware library elements and still simulate unknown-valued signals.

## SUMMARY OF THE INVENTION

According to the invention, in a circuit system simulation model which comprises a combination of the physical device to be modeled and means for controlling the physical device at normal operating speeds, a method is provided for propagating a simulated unknown-valued signal which comprises exciting the simulation model with a pattern sequence a plurality of times, during each excitation sequence changing at least one input value in the input sequence, comparing the sampled values of each resultant output signal, and setting or recognizing as unknown-valued any specific output signal which attains different values as a result of the change in the input sequence.

Unknown-valued signals are employed principally as an indicator of internal errors, e.g., timing or initialization errors. Not all unknown-valued signals need be identified by the above method. However, the fraction of unknown-valued signals which can be identified in actual practice by this method has been found to be large enough to make this method of great practical utility.

In a specific embodiment, a physical sample of the device being modeled, for example a dynamic or static digital circuit, such as a microprocessor circuit, is employed in a simulation model of a digital system, the system including other digital circuits to be simulated in the environment of the system. The physical sample, herein called the reference element, is coupled through a device herein designated as a personality module to a device herein designated as a simulation jig. The purpose of a personality module is to provide the electrical and physical configurations for interfacing the specific reference element with the simulation jig. The simulation jig is coupled to a computer controlled system, herein designated a logic-simulator, thereby to provide appropriate input signals and to sample the resulting output signals in such a way that the user need not be aware that the model is either a software or a hardware model. In fact, a user of a simulation library may mix components represented by software models with components having physical models without concern about type.

In a specific implementation of the invention, a sequence of input patterns is precomputed and stored in a fast memory. An input pattern is the parallel pattern of bits presented at a timed interval (clock edge) to the reference element. Thereafter, the sequence is played back to the reference element. At the end of the sequence of input patterns, the output values of the reference element output signals are sampled and saved. Some input values in patterns within the sequence are optionally modified, and the sequence of input patterns is repeated to the same termination point. The values of the output signals are then sampled again and compared with the saved values. This modification, repetition, sampling and comparison may be performed a number of times. Any difference indicates an unknown output value.

Employing the resultant output values, the logic-simulator according to the invention may compute, off-line, the next input pattern, store this computed input pattern at the end of the sequence of input patterns previously stored, reset the reference element, either by activating a reset signal line or applying a reset pattern sequence to the reference element, and then repeat the sequence of input patterns such that the next operational sequence produces the next set of output values.

The simulation model according to the invention thereby permits non-real-time simulation of systems, which is important to allow the use of software models for other devices in the digital system, while preserving the real-time characteristics of selected hardware reference elements of the system without having to generate a complex mathematical model of each element of the system under development or under test.

The invention will be better understood by reference to the following detailed description taken in connection with the accompanying drawings.

BRIEF DESCRIPTION OF THE DRAWINGS

Figure 1 is a block diagram of a simulation system with simulation modeling apparatus.

Figure 2 is a representation of a memory map of a computer controlled simulation system.

Figure 3 is a block diagram of a simulation jig according to the invention.

Figure 4 is a diagrammatic representation of a simulation task.

Figure 5 is a diagrammatic representation of the method in accordance with the invention for simulating unknown values.

DESCRIPTION OF SPECIFIC EMBODIMENTS

In order to better understand the invention, it is helpful to consider operation of a simulation system capable of employing the inventive method. The inventive method will then be illustrated by an example.

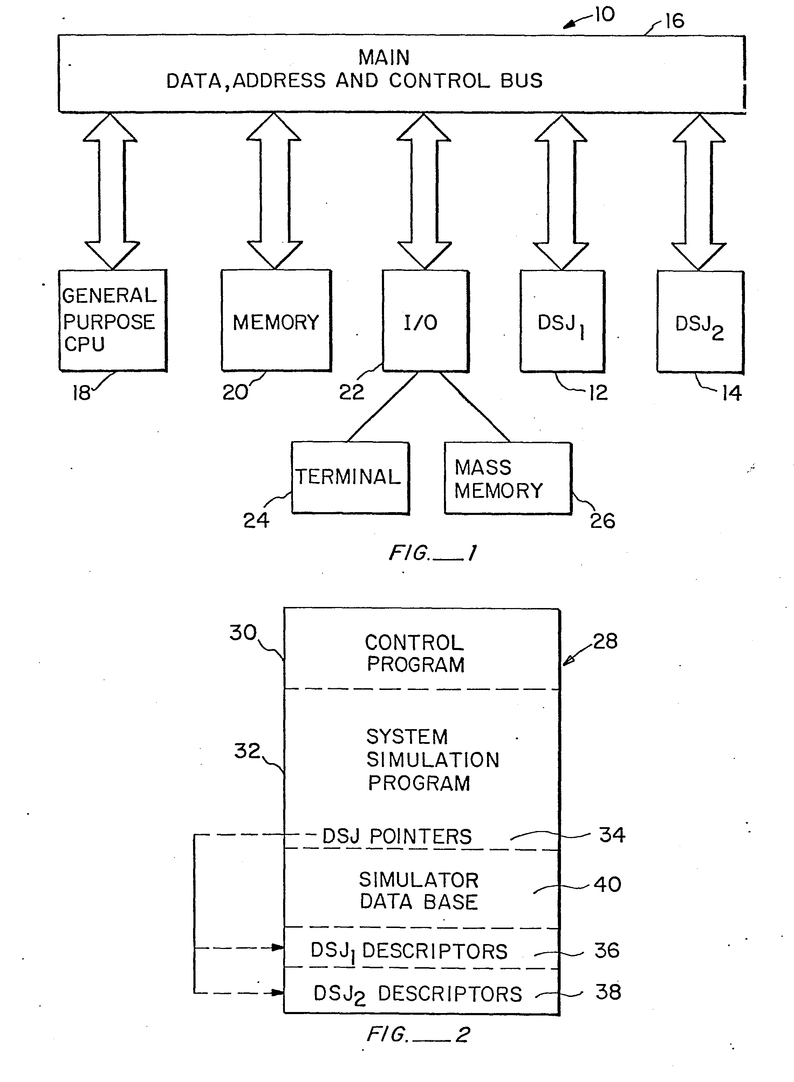

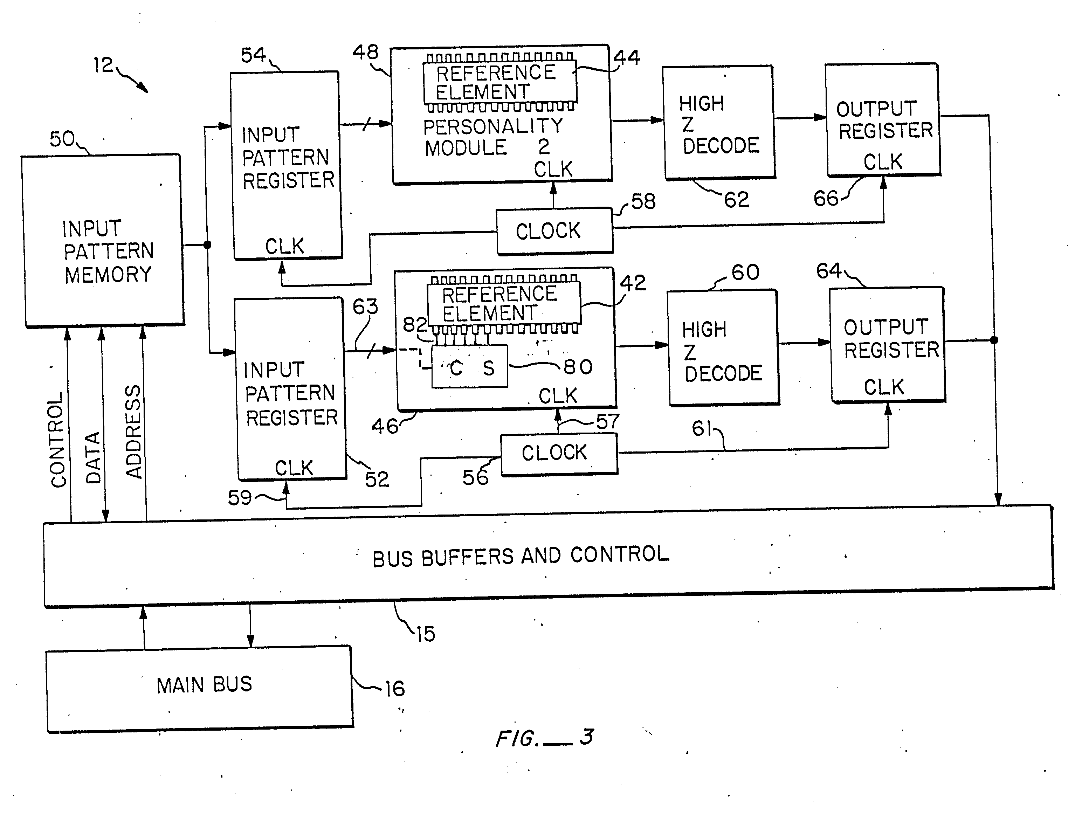

Referring to Figure 1, there is shown a simulation system 10 as might be configured in a general purpose digital computer having a general purpose central processing unit (CPU) 18 coupled to a main bus 16. The simulation system further may include a memory means 20 and input/output means (I/O) 22 coupled to the main bus 16. A control terminal 24 and mass memory 26 are coupled through the I/O 22 to the main bus 16. Whereas a completely software-based simulation requires no other hardware, in the present invention a first simulation jig (DSJ$_1$) 12 and/or a second simulation jig (DSJ$_2$) 14 may be coupled to the main bus 16. The functions of the simulation jigs 12 and 14 are explained in connection with Figure 3.

Referring to Figure 2, there is shown schematically how the software of the simulation system 10 may be organized in a memory map 28 of the memory 20. Memory space is set aside for a computer system control program 30 in memory 20. A system simulation program 32 is stored as object code in memory 20. Also stored in memory 20 are pointers 34 to descriptors 36 and 38 of the simulation jigs 12 and 14. A simulator database 40 containing working data values for the system simulation program is stored on-line in memory 20. Memory 20 is also used to store data as required by the simulation program from the mass memory 26.

Consider operation of a simulation jig 12 operative to present input patterns through an input pattern register 52 to a device herein known as a reference element 42, as shown in Figure 3. (Most control signal lines have not been shown to avoid unnecessary complexity. Implementation of control functions is within the skill of the original designer from the present description.) One or more clock signals having preselectable shape, clock rate and relative phase relationship may be presented by a clock 56 via clock lines 57, 59 and 61 to a personality module 46, the input pattern register 52 and the output register 64. The personality module 46 is a customized interface device which provides signal level matching and a suitable socket for a general purpose simulation jig 12. The simulation jig 12 is operative to present a set of input signals to the reference element 42 synchronous with the clock 56, which input signals represent values stored in an input pattern memory 50 containing the full set of defined input signal patterns in logical sequence. The input pattern memory 50 may be a serial or random access memory device with control lines and ports appropriate to the type of memory element selected.

At a fixed time relative to each clock period or edge, the input pattern register 52 of the simulation jig 12 is operative to produce output signals as if it were operating in a real-time environment in response to the defined input signal pattern. However, the output signals are ignored by the data recovery element, namely the output register 64, until all available input patterns in a sequence have been presented to the reference element 42. After the last input pattern has been presented to the reference element 42, clocking stops. An interval follows which is greater than the maximum specified delay of any output of the reference element 42. Thereupon the output values are sampled and stored in the output register 64. Thereafter, the simulator system 10 (Figure 1) to which the simulation jig 12 is coupled via bus buffers and control 15 and main bus 16 examines the state of each output of the reference element 42. The states are evidenced by the values in the output register 64. The simulator system 10 then schedules the simulated outputs in the simulator data base 40 to change at specific delay times after the corresponding input transition. The specified delay time for each output is a function of the identity of the output which changes and the identity of the input which causes the change. It can be set to any time value between the minimum and the maximum delay as specified by the manufacturer and is a parameter which is specified in the definition of the device corresponding to the reference element 42. (Experience suggests that the maximum delay time be chosen in order to reveal the most timing errors in a design under development.)

The simulator system 10, having set up a schedule for simulated output signals from the reference element 42, proceeds to advance the state of the simulator data base 40 by computing other necessary values and advancing simulated time until the occurrence of the next simulated input change or clock edge. The simulation system 10 then records the instantaneous values of the simulated input signals which are defined for the reference element 42 and stores them in the next location in the input pattern memory 50. The simulation system 10 then generates a reset pattern sequence or a reset signal which is conveyed to the reference element 42 via one or more of the lines of coupling 63 and prepares the reference element 42 to repeat the process of cycling through all patterns. Thereafter, the entire set of defined input signal patterns, including the newly computed pattern, is presented in sequence to the reference element 42 through the personality module 46 within the predefined time tolerance for the input signals. This process is repeated until all operations of a simulation have been executed and all defined patterns of a sequence applied to the reference element 42 have been executed.

Referring to Figure 4 there is shown a diagrammatic representation of a specific simulation task according to the invention. The task is to simulate the consequences of applying unknown values U to a first input terminal x, and at other input terminals such as second input terminal y, at an arbitrary time $t_x$ in an input sequence 102. Figure 4 illustrates a sequence of signals in the form of binary 1's and 0's and unknowns applied to input terminals x and y and derived from an output terminal z of a reference element 44.

An output sequence 112 at output terminal z is generated which must reflect the consequences of the unknown values U at time $t_x$ and later. It is understood that the representation is elementary in that many input terminals and many output terminals may be effected and that the input sequence may be very long and may vary from simulation task to simulation task.

In the specific example, two unknown values U are applied simultaneously at the fourth pattern time, and the output value at the fourth pattern time may have some effect on the value of the x input at pattern times $t_{x+1}$ and later due to feedback circuitry in the simulated system.

According to the invention, unknown values are modeled by real known values, and a statistically significant set of alternative sequences is applied to the reference element 44. The sequences consist of only real binary valued signals, that is, digital 1's or 0's. The results of output sequences are then examined and compared with each other to determine how the unknown values propagate through the reference element 44 and effect outputs, if at all.

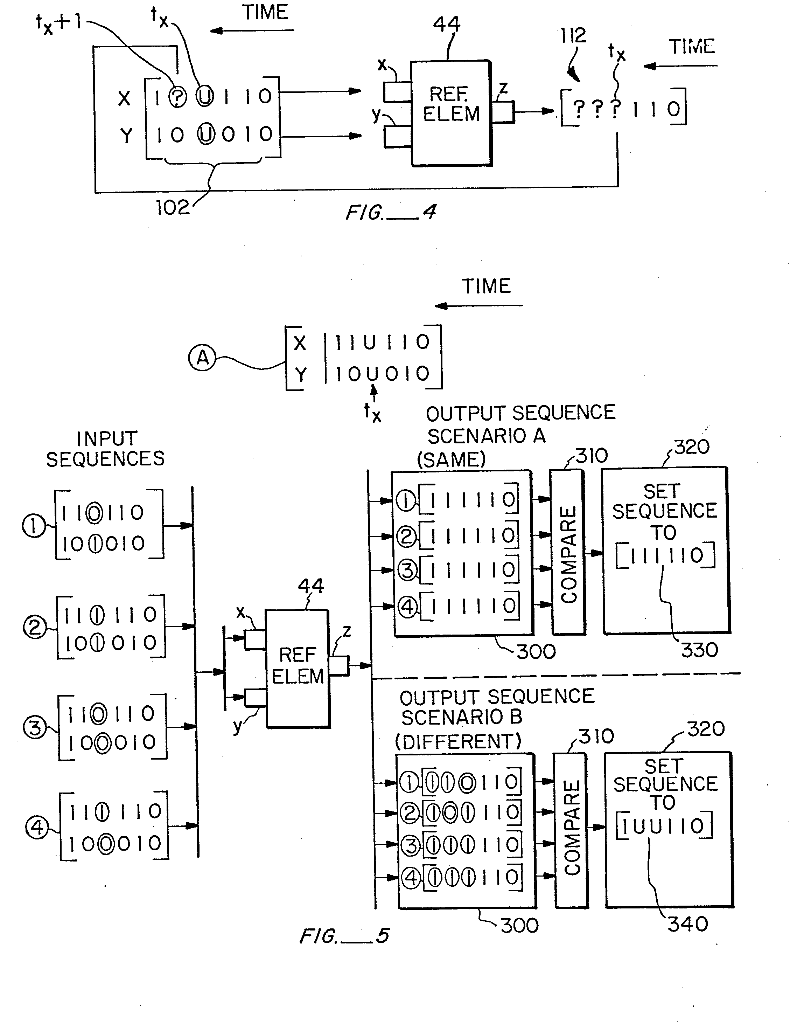

Figure 5 illustrates the method according to the invention. The pattern A of sequences X and Y represents the input sequences to input terminals x and y wherein there are two unknown values U at time $t_x$. There are four possible combinations of two unknowns, namely 0 1 ; 1 1 ; 0 0 ; and 1 0, as shown by input sequences 1, 2, 3 and 4, respectively. In general, there are $2^n$ possibilities for n unknown binary input values.

In order to determine what the output responses to such sequences are, all of the possible sequences may be presented, one sequence at a time, to the input terminals x and y of the reference element 44. The resulting sequences of output signals at the output terminal z are registered and preserved for example in a buffer memory 300. Each of the output sequences so generated is then compared by a comparator 310 sample by sample, with each of the other sequences to identify any differences. If no difference exists between any of the sequences, then it can be concluded that the unknown values presented at the input terminals x and y did not propagate through the reference element 44 to output terminal z. A simulator function element 320 then sets the output sequence, as in Scenario A, to the unambiguous sequence 330. If differences are identified, as in Scenario B, then it can be concluded that the unknown values in fact propagate through the reference element 44. The simulator function element 320 may then set the differing samples in the resultant output sequence 340 to "unknown" to reflect the propagation of unknowns through the reference element 44. The resultant output sequence 340 is then applied to the subsequent output utilization device (not shown).

In actual simulators, the number of input terminals and the length of input patterns render impractical the presentation to the reference element of every possible input sequence variation representing an input sequence containing unknown values both because of limitations on memory size and because of constraints of time. Statistically, most unknown output samples can be identified by presenting only a small faction of the possible input sequences. At least two patterns are always required. The two patterns can be of arbitrary length and differ at as few as one sample to as much as every sample.

The invention has now been explained with reference to specific embodiments. Other embodiments will be apparent to those of ordinary skill in the art. Therefore, it is not intended that this invention be limited, except as indicated by the appended claims.

## CLAIMS

WHAT IS CLAIMED IS:

1. In an apparatus for simulating operation of a digital circuit system, a method for modeling operation of a complex digital device in said digital circuit system wherein a physical specimen of said complex digital device is employed as an operational reference element, said method comprising the steps of:

presenting to at least one input terminal of said complex digital device a first sequence of digital-valued signals;

registering a first response responsive to said first sequence at at least one selected output terminal of said complex digital device;

presenting to said complex digital device input terminal a second sequence of digital-valued signals under identical conditions to said presenting of said first sequence of digital-valued signals, wherein the value of at least one element in said second sequence differs from the value of the corresponding element in said first sequence in order to represent an unknown input value;

registering a second response responsive to said second sequence at said complex digital device output terminal;

comparing, sample for sample, values of said first response with values of said second response; and

in the event values of said first response differ from values of said second response at said digital device output terminal generating an output signal indicating occurrence of a response difference.

2. The method according to claim 1 wherein said presenting steps occur at a clock rate which differs from a clock rate associated with operating said simulation system.

3. The method according to claim 1 further including the step of generating a specific predefined output signal having a digital value representation for any sample which produces a response whose values do not differ as between said first sequence and said second sequence.

4. The method according to claim 1 wherein said response difference indicating output signal is a signal specifying those values of said first response and said second response are unknown.

5. The method according to claim 1 wherein only a fraction of possible input sequence variations is presented to said input terminal.

6. The method according to claim 5 wherein the fraction is less than one-half.

7. The method according to claim 5 wherein at least two sequences are employed.

8. The method according to claim 4 wherein said response difference indicating output signal is substituted for each element of said response signal where said response difference is identified for use in identifying causes of said response difference.

0150258

FIG.\_\_1

FIG.\_\_2

FIG.—3

0150258

FIG.__4

FIG.__5